(19) Europäisches Patentamt

European Patent Office

Office européen des brevets

(11) Publication number: **0 233 075 B1**

## (12) EUROPEAN PATENT SPECIFICATION

(45) Date of publication of patent specification: **27.10.93**

(21) Application number: **87301126.6**

(22) Date of filing: **10.02.87**

(51) Int. Cl.⁵: **H03M 13/00**, //G11B20/18

---

(54) **Method and apparatus for generating error detection check bytes for a data record.**

---

(30) Priority: **10.02.86 US 828101**

(43) Date of publication of application:
**19.08.87 Bulletin 87/34**

(45) Publication of the grant of the patent:
**27.10.93 Bulletin 93/43**

(84) Designated Contracting States:
**DE FR GB IT**

(56) References cited:
**EP-A- 0 061 288**
**EP-A- 0 094 671**
**EP-A- 0 117 287**
**FR-A- 2 443 171**

**IBM TECHNICAL DISCLOSURE BULLETIN. vol. 15, no. 4, September 1972, NEW YORK US pages 1314 - 1315; P. BOUDREAU ET AL.: "PARALLEL CRC GENERATION FOR MULTI-LENGTH CHARACTERS"**

**IBM JOURNAL OF RESEARCH AND DEVELOPMENT. vol. 24, no. 1, January 1980, NEW YORK US pages 32 - 42; ARVIND PATEL: "ERROR RECOVERY SCHEME FOR THE IBM 3850 MASS STORAGE SYSTEM"**

(73) Proprietor: **International Business Machines Corporation**
**Old Orchard Road**
**Armonk, N.Y. 10504(US)**

(72) Inventor: **Patel, Arvind Motibhai,**
**6583 San Ignacio Avenue,**
**San Jose California 95119(US)**

(74) Representative: **Atchley, Martin John Waldeg-rave**
**IBM United Kingdom Limited**
**Intellectual Property Department**
**Hursley Park**
**Winchester Hampshire SO21 2JN (GB)**

**EP 0 233 075 B1**

## Description

The present invention relates to arrangements and methods for detecting and correcting errors in records including sequences of data bytes and error detection and correction check bytes.

The invention is related to the invention described in the Specification of European Patent Application No. 86307326.8 published as EP-A 0218413. This specification is incorporated herein by reference as if fully set forth herein.

A cyclic redundancy check (CRC) operation on a sequence of data bytes is extremely efficient and well suited for error detection in the transmission, retrieval or storage of variable length records of binary data including such sequences. A CRC operation is capable of detecting nearly all patterns of error with almost negligent amount of redundancy.

CRC operations are also very well known. See, for example, "Cyclic Codes for Error Detection", W. W. Peterson and D. T. Brown, Proceedings of the IRE, pages 228 to 235, January, 1961, and "A Multi-channel CRC Register", Arvind M. Patel, Spring Joint Computer Conference, 1971.

A linear feedback register is essentially the only hardware needed for encoding and decoding a record comprising a variable length sequence of binary data for error detection by means of the use of a CRC check byte. The CRC byte may be generated using a GF(2) polynomial divider circuit. In such a circuit, the sequence of binary data is serially shifted into a feedback shift register as the data is transmitted. The CRC check byte generated is transmitted at the end of the binary data sequence and received in sequence at the receiver. The CRC check byte as generated is then compared with the CRC check byte as received for detection of any errors in the received record which is processed in the same manner by a feedback shift register. The number of digits in the CRC check byte determines the checking capability of the code and, in general, equals the number of stages of the encoding and decoding shift register.

The object of the present invention is to provide an improved apparatus and method for generating a set of CRC check bytes for a variable length record.

The present invention relates to apparatus for generating a set of CRC check bytes for a variable length record formed as a sequence of data bytes and error correction check (ECC) bytes inserted into the sequence of data bytes at preselected intervals, the ECC bytes being calculated using powers of a companion matrix T derived from an irreducible polynomial, the apparatus comprising a computing system adapted to operate on said sequence of data bytes and ECC bytes in order to generate said set of CRC check bytes.

According to the invention the apparatus is characterised in that said computing system comprises:

first computing means for generating a first subset of CRC check bytes by sequentially receiving said sequence of data bytes and ECC bytes in said record and for each CRC check byte calculating $\Sigma\, T^{(-ni)}\, D_i$, where $D_i$ is the ith value in said sequence of data bytes and ECC bytes after excluding a first preselected set of ECC bytes, T is the companion matrix used for computing said ECC bytes, and n is an integer different from any of the powers used for computing said ECC bytes or any other CRC check bytes;

second computing means for generating a second subset of CRC check bytes, each paired with a CRC check byte in said first subset, by sequentially receiving said sequence of data bytes and ECC bytes in said record and for each CRC check byte calculating $\Sigma\, T^{(n+1)i}\, Z_i$, where $Z_i$ is the ith value in said sequence of data bytes and ECC bytes after excluding a second preselected set of ECC bytes, and where n has the same value as used to generate the paired CRC check byte from the first subset; and

means for combining said first and second subsets of CRC check bytes so as to generate said set of CRC check bytes.

The invention also relates to a method of generating a plurality of CRC check bytes for a variable length record formed as a sequence of data bytes and error correction check (ECC) bytes inserted into said sequence of data bytes at preselected intervals, the ECC bytes being calculated using powers of a companion matrix T derived from an irreducible polynomial, comprising performing a computation operation on said sequence of data bytes and ECC bytes in order to generate said set of CRC check bytes.

According to the invention, the method is characterised in that said computation operation comprises:

generating a first subset of CRC check bytes by sequentially receiving said sequence of data bytes and ECC bytes in said record and for each CRC check byte calculating $\Sigma\, T^{(-ni)}\, D_i$, where $D_i$ is the ith value in said sequence of data bytes and ECC bytes after excluding a first preselected set of ECC bytes, T is the companion matix used for computing said ECC bytes, and n is an integer different from any of the powers used for computing said ECC bytes or any other CRC check bytes;

generating a second subset of CRC check bytes, each paired with a CRC check byte in said first subset, by sequentially receiving said sequence of data bytes and ECC bytes in said record and for each CRC check byte calculating $\Sigma\, T^{(n+1)i}\, Z_i$, where $Z_i$ is the ith value in said sequence of data bytes and ECC

2

bytes after excluding a second preselected set of ECC bytes, and where n has the same value as used to generate the paired CRC check byte from the first subset; and

combining said first and second subsets of CRC check bytes so as to generate said set of CRC check bytes.

The CRC check bytes are created in pairs and each computed using different powers of the T matrix. The T matrix is the companion matrix of an irreducible polynomial, $G(x)$, which is the same as that used for computing other associated ECC check bytes for the record. In many practical applications $G(x)$ is a degree-eight primitive polynomial.

Use of the same T matrix provides computational convenience not found in conventional CRC implementations which typically employ a high degree (e. g. degree 16) polynomial divider to obtain long cycle length. The longer the cycle length, the less chance two errors in the same record will cancel; therefore, cycle length must be longer than the record. The present invention obtains long cycle lengths while operating in a reasonable size Galois field, such as $GF(2^8)$ instead of a larger field $GF(2^{16})$ in a conventional CRC operation.

The check bytes generated in accordance with the invention are also useful in two-level error correction code configurations such as that described in the European Patent Application referred to above. In the arrangement described in that Application, a variable length record is divided into subblocks, each of which has 2 x 2 check bytes of the two-way interleaved cyclic codeword for single error correction and 1 x 2 extension check bytes for double error detection. At the second level, correction of a double burst error in one subblock is provided by reprocessing the subblock check bytes with additional 1 x 2 extension check bytes at the end of the block. Four additional check bytes at the end of the block are CRC check bytes which provide substantially strong data integrity check after ECC correction and these CRC check bytes and may be generated in accordance with the present invention.

When the CRC check bytes are used in the two-level ECC (error correction code) scheme described above, use of the same T matrix provides computational convenience when second level error correction requires recomputation of CRC bytes.

In order that the invention may be more readily understood an embodiment will now be described with reference to the accompany drawings, in which:

Fig. 1 is a block diagram of the logic for an encoding feedback shift register which can be used to generate CRC check bytes according to the principles of the present invention,

Fig. 2 is a block diagram of the logic for a feedback shift register for simultaneous decoding of data and error patterns utilising CRC check bytes generated according to the principles of the present invention, and

Fig. 3 is a diagrammatic illustration showing the format of data bytes and subblock and block check bytes at the end of a two-level encoded record configured for a disk memory track constructed and including CRC check bytes generated according to the principles of the present invention.

The present invention relates to the generation of check bytes CRC for a record of the type which includes blocks of data bytes in sequence. Each block includes one or more subblocks and error correction check bytes. Each sub block includes data bytes and error correction check bytes.

The four check bytes to be generated for the records, CRC1, CRC2, CRC3, CRC4, are defined by the following equation:

$$CRC1 = \sum_{i} T^{-i} D_i \qquad (1)$$

$$CRC2 = \sum_{i} T^{-2i} Z_i \qquad (2)$$

$$CRC3 = \sum_{i} T^{-3i} D_i \qquad (3)$$

$$CRC4 = \sum_{i} T^{-4i} Z_i \qquad (4)$$

in which the byte sequences $D_i$ and $Z_i$ are as defined below.

The matrix T is a companion matrix of a degree-eight primitive polynomial, G(x). The polynomial is given by

$$G(x) = g_0 \oplus g_1 x \oplus g_2 x^2 \oplus ... \oplus g_7 x^7 \oplus x^8, \qquad (5)$$

where $\oplus$ signifies modulo-2 sum.

Different powers of the same primitive element (matrix) T are used to create check bytes for all CRC operations as well as performing ECC functions as will be described below. The matrix T of the polynomial G(x) is given by the following non-singular matrix

$$T = \begin{bmatrix} 0 & 0 & 0 & 0 & 0 & 0 & 0 & g_0 \\ 1 & 0 & 0 & 0 & 0 & 0 & 0 & g_1 \\ 0 & 1 & 0 & 0 & 0 & 0 & 0 & g_2 \\ 0 & 0 & 1 & 0 & 0 & 0 & 0 & g_3 \\ 0 & 0 & 0 & 1 & 0 & 0 & 0 & g_4 \\ 0 & 0 & 0 & 0 & 1 & 0 & 0 & g_5 \\ 0 & 0 & 0 & 0 & 0 & 1 & 0 & g_6 \\ 0 & 0 & 0 & 0 & 0 & 0 & 1 & g_7 \end{bmatrix} \qquad (6)$$

Referring to Equations (1) - (4), the byte sequence $[D_i]$ consists of all data bytes in the record to be checked for errors and all first level error correction check bytes, but excludes second level error correction check bytes. The byte sequence $[Z_i]$ consists of the same data and check bytes but further excludes two check bytes corresponding to the last two byte positions of each subblock of the record (except the last subblock) to create a recurring, two-byte offset between sequences $[D_i]$ and $[Z_i]$. The two check bytes are excluded by inhibiting the clock signal which controls the shift register processing of the byte sequence $[Z_i]$ for two cycles.

The first-level check bytes in these byte sequences (and the corresponding error patterns) may be replaced by null bytes (i.e. all zeroes) in CRC calculations. Such use of null bytes will eliminate the need for correcting errors, if any, in the ECC check bytes.

The byte sequence $[Z_i]$ is offset from the byte sequence $[D_i]$ by two bytes at the end of each subblock. When G(x) is a degree-8 primitive polynomial, the exponent for matrices $T^{-1}$ and $T^{-2}$ is 255. If a typical subblock is 102 bytes long, the recurring offset arrangement provides combined effective cycle lengths of two CRC checks for sequences $[D_i]$ and $[Z_i]$ as given below:

$255 \times 102 = 26{,}010$ bytes for $[D_i]$, and
$255 \times 100 = 25{,}500$ bytes for $[Z_i]$.

Thus, two identical detectable error patterns will not cancel each other simultaneously in both types of CRC check for any record comprising up to 255 subblocks of data bytes.

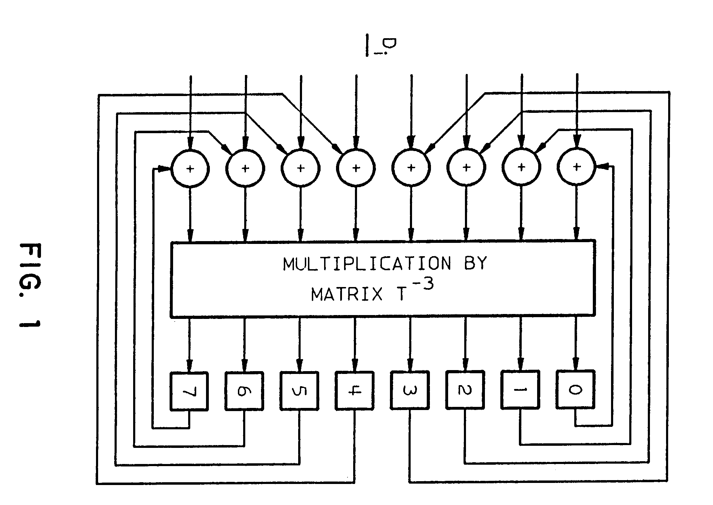

The four check bytes, CRC1, CRC2, CRC3 and CRC4, are generated or computed by means of four 8-bit shift registers 1, 2, 3 and 4 with premultipliers $T^{-1}$, $T^{-2}$, $T^{-3}$ and $T^{-4}$, respectively and each of the type illustrated in Figure 1. The sequence $[D_i]$ is entered into shift registers 1 and 3 with premultipliers $T^{-1}$ and $T^{-3}$, respectively. Similarly, the sequence $[Z_i]$ is entered into shift registers 2 and 4 with premultipliers $T^{-2}$ and $T^{-4}$, respectively. The subscript "i" counts from high to low and the last bytes are identified by $D_1$ and $Z_1$ in their respective sequences.

By way of example, for computing all CRC bytes a typical encoder configuration for implementing Equation (3) is shown in Fig. 1.

When the last bytes have been entered during the check byte computing operation, the contents of the four shift registers are shifted through 0, 1, 2 and 3 additional cycles, respectively, with null (all zeroes) input. The final contents of the shift registers comprise the four check bytes.

During the process of reading the data record after transmission in order to check for errors, CRC error syndromes may be generated on-the-fly along with the ECC error syndromes as the data bytes are received. Of course, the CRC error syndromes also must be adjusted for first and second-level error correction. The equations for the four CRC error syndromes, $S_{-1}$, $S_{-2}$, $S_{-3}$ and $S_{-4}$ are given by

$$S_{-1} = \hat{CRC1} \oplus \sum_i T^{-i} \hat{D}_i \oplus \sum_i T^{-i} E_1(D_i) \oplus \sum_i T^{-i} E_2(D_i) \quad (7)$$

$$S_{-2} = \hat{CRC2} \oplus \sum_i T^{-2i} \hat{Z}_i \oplus \sum_i T^{-2i} E_1(Z_i) \oplus \sum_i T^{-2i} E_2(Z_i) \quad (8)$$

$$S_{-3} = \hat{CRC3} \oplus \sum_i T^{-3i} \hat{D}_i \oplus \sum_i T^{-3i} E_1(D_i) \oplus \sum_i T^{-3i} E_2(D_i) \quad (9)$$

$$S_{-4} = \hat{CRC4} \oplus \sum_i T^{-4i} \hat{Z}_i \oplus \sum_i T^{-4i} E_1(Z_i) \oplus \sum_i T^{-4i} E_2(Z_i) \quad (10)$$

The symbols $\hat{\ }$ indicates readback bytes, and $E_1(D_i)$ and $E_1(Z_i)$ represent the first level error correction patterns and $E_2(D_i)$ and $E_2(Z_i)$ represent the second level error correction patterns corresponding to the sequences of bytes $D_i$ and $Z_i$, respectively. The error patterns corresponding to the check bytes are replaced by null bytes.

The data sequence $[\hat{D}_i]$ and the corresponding sequence of error-correction patterns $[E_1(D_i)]$ appear at the input and output of the first level decoder, respectively. If second level error correction is required, then the error correction patterns $[E_2(D_i)]$ will be available for decoding at the second level.

If the first level decoder includes a subblock buffer and on-the-fly error correction, then first level CRC error syndromes can be computed from the corrected data which is the combined sequence $[D_i + E_1(D_i)]$. However, if the first-level error correction is deferred, then the subblock buffer and the corrected data sequence may not be readily available. In that case, the CRC error syndromes may be computed by combining partial computations.

Syndrome $S_{-3}$ is used to illustrate the process which is applicable to all CRC error syndromes. The partial computations of Equation (9) are defined as

$$S_{-3}(0) = \hat{CRC3} \oplus \sum_i T^{-3i} D_i \qquad (11)$$

$$S_{-3}(1) = S_{-3}(0) \oplus \sum_i T^{-3i} E_1(D_i) \qquad (12)$$

$$S_{-3}(2) = S_{-3}(1) \oplus \sum_i T^{-3i} E_2(D_i) \qquad (13)$$

where $S_{-3}(0)$, $S_{-3}(1)$ and $S_{-3}(2)$ denote the values for $S_{-3}$ with no error correction, first level error correction and second level error correction, respectively.

Corresponding equations for partial computations of Equations (7), (8) and (10) are given in the Appendix at the end of this description.

Equations (11) and (12) can be implemented using two shift registers (each similar to the one shown in Fig. 1) for processing the uncorrected sequence $[D_i]$ and the first level error correction pattern $[E_1(D_i)]$ separately. Each shift register will use the multiplier $T^{-3}$. The first shift register provides a sufficient CRC check if no errors were corrected. This check is available immediately at the end of the record. When first-level error correction is required, the second shift register provides the CRC check with one-subblock delay from the end of the record.

Preferably, however, the two sequences $[D_i]$ and $[E_1(D_i)]$ can be processed in one shift register. The one subblock delay between these two sequences creates a delay of exactly 102 byte positions between them. If a count-down clock j, synchronised to the output of the first-level decoder, is used, then $E_1(D_j)$ appears at the output in synchronism with $\hat{D}_{j-102}$ at the input.

Equations (11) and (12) can be combined and rewritten in terms of j as

$$S_{-3}(1) = CRC3 \oplus \sum_{j=1}^{L+102} T^{-3j} [T^{3 \times 102} \hat{D}_{j-102} \oplus E_1(D_j)] \qquad (14)$$

where L is the length of sequence $[D_i]$. Note that $E_1(D_j)$ for j>L and $D_{j-102}$ for j≤102 do not exist, they are null bytes.

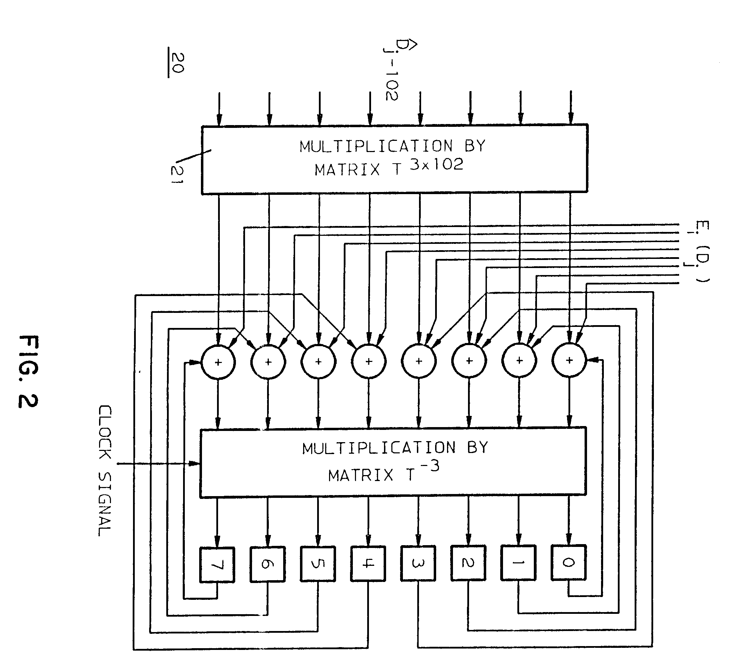

Equation (14) may be implemented with a shift register 20 as shown in Fig. 2 in which the sequence $[D_j]$ enters through a premultiplier $T^{3 \times 102}$ (21) and is added to the sequence $(E_1(D_j))$ at the input as the clock parameter j counts down from L + 102 to 1. The sequence $[\hat{D}_j]$ starts at j = L + 102 and ends at j = 103. The sequence $E_1(D_j)$ starts at j = L and continues after j = 102 to the end j = 1. The final content of the shift register, when combined with $\hat{CRC3}$, yields $S_{-3}(1)$.

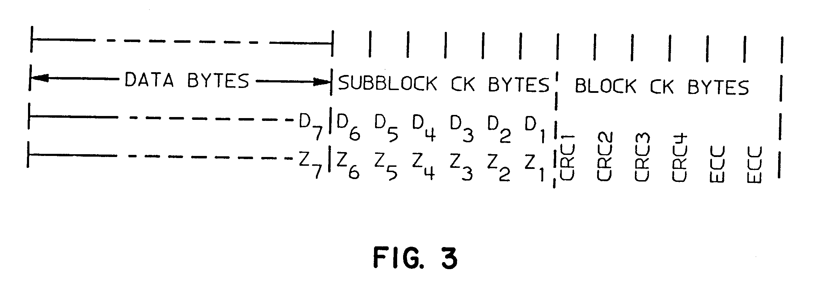

Referring to Fig. 3, all four readback CRC check bytes at the end of the record also may be processed through a corresponding shift register along with the data during the readback process. Just as null bytes are entered for subblock check bytes during encoding, null bytes are also entered for the CRC check byte positions at the end of the record. Similarly, null bytes are entered again for syndrome generation during the readback process. For example, check byte CRC3 is physically offset two byte positions away from the last byte, $D_1$, of sequence $[D_i]$ as shown in Fig. 3. Thus, two additional null bytes are entered into the shift register for the CRC3 check byte after byte $D_1$ during encoding as well as during syndrome generation.

Readback check byte $\hat{CRC3}$ is processed through premultiplier 21 in shift register 20 (Fig. 2) after byte $D_1$ and two null bytes. At the end of entering sequence $[E_1(D_i)]$ two null bytes need not be entered. The final contents of shift register 20 therefore is syndrome $S_{-3}(1)$. The contents of shift register 20 upon entering the last readback check byte CRC3 provides sufficient CRC check if no errors were corrected. In particular the content at j = 102 is 0, if and only if, syndrome $S_{-3}(1)$ is 0. Thus, if all ECC error syndromes are 0, the immediate contents of the CRC registers at the end of the record provide a complete CRC check without requiring the final 100 shifting operations. Since most data records are error-free, this feature provides substantial performance advantage.

The other CRC error syndromes are computed in like manner. Syndrome $S_{-1}$, given by Equation (7), merely requires different multiplier circuits, namely, $T^{-1}$ and $T^{102}$ in place of those shown in Fig. 2. Syndromes $S_{-2}$ and $S_{-4}$ require processing of sequences $[\hat{Z}_i]$ and $[E_1 (Z_i)]$, in which one subblock delay equals 100 byte positions between them. Thus, the corresponding multiplier circuits for $S_{-2}$ are $T^{-2}$ and $T^{2 \times 100}$, and for $S_{-4}$ are $T^{-4}$ and $T^{4 \times 100}$.

Just as for CRC3, any other CRC check byte may be processed along with the data through its shift register by allowing an appropriate number of cycles with null byte input during encoding or syndrome generation operations. In particular, check bytes CRC1, CRC2, CRC3 and CRC4 require 0, 1, 2 and 3 additional cycles, respectively, with null byte input at the ends of their sequences $[D_i]$ and $(\hat{D}_i)$ or $[Z_i]$ and $[\hat{Z}_i]$.

If no errors are present, all CRC error syndromes will be 0. If second level error correction is required, one of the subblocks with up to four byte error corrections will be involved. Byte count "i" in sequence $[D_i]$ for each of the four error bytes will be determined from the error location numbers generated by the second-level ECC decoders described in the Specification of European Patent Application No. 86307326.8. Thereafter, for Equation (13), the term "$T^{-3i} E_2(D_i)$" for each i can be computed using the same log and antilog tables as those used by the ECC decoder employing the relation

$$T^{-3i} E_2 (D_i) = \log^{-1} \{[\log E_2(D_i) - 3i] \text{ modulo } 255\}. \qquad (15)$$

When added to the previously computed $S_{-3}$ (1), the final CRC check of Equation (9) corresponding to the CRC error syndrome $S_{-3}$ is now complete.

Similarly, the byte count i in sequence $[Z_i]$ for each of the four errors will also be determined. Computations for syndromes $S_{-1}$, $S_{-2}$, $S_{-3}$ and $S_{-4}$ will be done in like manner. The final values of these CRC error syndromes must be all zero if all errors are corrected properly and no errors are present.

Errors in CRC check bytes will tend to create unnecessary reread operations with undue performance penalty. In order to avoid such performance penalty, operational rules which balance adequate error correction and detection capability against unnecessary reread operations may be adopted.

Rule 1: All CRC check bytes may be ignored if subblock level and block level ECC error syndromes are zero.

Rule 2: One non-zero CRC check byte on $[D_i]$ sequence and one such CRC check byte on $[Z_i]$ sequence may be ignored if second level correction is not required.

Rule 3: Block level ECC check byte may be ignored if all CRC checks are zero and second level correction is not required.

Rule 2 allows errors in up to two CRC check bytes, one each in sequences $[D_i]$ and $[Z_i]$, thereby retaining the benefit of the offset between such sequences. In order to balance the errors in the odd and even phases, odd phase CRC check bytes, namely CRC1 and CRC3, are generated from the $[D_i]$ sequence and the even phase CRC check bytes, namely CRC2 and CRC4, are generated from the $[Z_i]$ sequence.

As will be apparent from the above description, the use of four separate CRC check bytes derived from the same primitive field element in $GF(2^8)$ provides not only computational convenience but also a better error checking operation. The recurring offset of the sequences $[D_i]$ and $[Z_i]$ provides desired long cycle length without using degree-16 polynomials.

APPENDIX

For Equation (7),

$$S_{-1}(0) = \hat{CRC1} \oplus \sum_i T^{-i} \hat{D}_i \qquad (7A)$$

$$S_{-1}(1) = S_{-1}(0) \oplus \sum_i T^{-i} E_1(D_i) \qquad (7B)$$

$$S_{-1}(2) = S_{-1}(1) \oplus \sum_i T^{-i} E_2(D_i); \qquad (7C)$$

For Equation (8),

$$S_{-2}(0) = \hat{CRC2} \oplus \sum_i T^{-2i} \hat{Z}_i \qquad (8A)$$

$$S_{-2}(1) = S_{-2}(0) \oplus \sum_i T^{-2i} E_1(Z_i) \qquad (8B)$$

$$S_{-2}(2) = S_{-2}(1) \oplus \sum_i T^{-2i} E_2(Z_i) \qquad (8C)$$

For Equation (10),

$$S_{-4}(0) = \hat{CRC4} \oplus \sum_i T^{-4i} \hat{Z}_i \qquad (10A)$$

$$S_{-4}(1) = S_{-4}(0) \oplus \sum_i T^{-4i} E_1(Z_i) \qquad (10B)$$

$$S_{-4}(2) = S_{-4}(1) \oplus \sum_i T^{-4i} E_2(Z_i) \qquad (10C)$$

## Claims

1. Apparatus for generating a set of CRC check bytes for a variable length record formed as a sequence of data bytes and error correction check (ECC) bytes inserted into the sequence of data bytes at

8

preselected intervals, the ECC bytes being calculated using powers of a companion matrix T derived from an irreducible polynomial, the apparatus comprising a computing system adapted to operate on said sequence of data bytes and ECC bytes in order to generate said set of CRC check bytes;

characterised in that said computing system comprises;

first computing means for generating a first subset of CRC check bytes by sequentially receiving said sequence of data bytes and ECC bytes in said record and for each CRC check byte calculating $\Sigma$ $T^{(-ni)} D_i$, where $D_i$ is the ith value in said sequence of data bytes and ECC bytes after excluding a first preselected set of ECC bytes, T is the companion matrix used for computing said ECC bytes, and n is an integer different from any of the powers used for computing said ECC bytes or any other CRC check bytes;

second computing means for generating a second subset of CRC check bytes, each paired with a CRC check byte in said first subset, by sequentially receiving said sequence of data bytes and ECC bytes in said record and for each CRC check byte calculating $\Sigma$ $T^{(n+1)i} Z_i$, where $Z_i$ is the ith value in said sequence of data bytes and ECC bytes after excluding a second preselected set of ECC bytes, and where n has the same value as used to generate the paired CRC check byte from the first subset; and

means for combining said first and second subsets of CRC check bytes so as to generate said set of CRC check bytes.

2. Apparatus as claimed in claim 1, for operating on a record formed as a sequence of data bytes and a set of first level error correction check bytes and a set of second level error correction check bytes,

characterised in that,

said first preselected set of error correction check bytes comprises all said second level error correction check bytes, and

said second preselected set of error correction check bytes comprises a predetermined number of first level error correction check bytes.

3. Apparatus as claimed in claims 1 or 2 characterised in that said first and second sub-sets of CRC check bytes each contain two check bytes.

4. A method of generating a plurality of CRC check bytes for a variable length record formed as a sequence of data bytes and error correction check (ECC) bytes inserted into said sequence of data bytes at preselected intervals, the ECC bytes being calculated using powers of a companion matrix T derived from an irreducible polynomial, comprising performing a computation operation on said sequence of data bytes and ECC bytes in order to generate said set of CRC check bytes,

characterised in that said computation operation comprises:

generating a first subset of CRC check bytes by sequentially receiving said sequence of data bytes and ECC bytes in said record and for each CRC check byte calculating $\Sigma$ $T^{(-ni)} D_i$, where $D_i$ is the ith value in said sequence of data bytes and ECC bytes after excluding a first preselected set of ECC bytes, T is the companion matix used for computing said ECC bytes, and n is an integer different from any of the powers used for computing said ECC bytes or any other CRC check bytes;

generating a second subset of CRC check bytes, each paired with a CRC check byte in said first subset, by sequentially receiving said sequence of data bytes and ECC bytes in said record and for each CRC check byte calculating $\Sigma$ $T^{(n+1)i} Z_i$, where $Z_i$ is the ith value in said sequence of data bytes and ECC bytes after excluding a second preselected set of ECC bytes, and where n has the same value as used to generate the paired CRC check byte from the first subset; and

combining said first and second subsets of CRC check bytes so as to generate said set of CRC check bytes.

5. A method as claimed in claim 4, for operating on a record formed as a sequence of data bytes and a set of first level error correction check bytes and a set of second level error correction check bytes,

characterised in that

said first preselected set of error correction check bytes comprises all said second level error correction check bytes, and

said second preselected set of error correction check bytes comprises a predetermined number of said first level correction check bytes.

6. A method as claimed in claims 4 or 5 characterised in that said first and second sub-sets of CRC check bytes each contain two check bytes.

7. Error correction apparatus, for performing an error correction operation on a record including a plurality of CRC check bytes (CRC) generated by a method as claimed in claim 4, said apparatus comprising a computing system for computing the value of two CRC error syndromes for use in said error correction operation,

characterised in that said computing system comprises

first error syndrome computing means for computing the value of a first CRC error syndrome $S_{-n}$-(1) adjusted for error correction in accordance with the relation

$$S_{-n}(1) = \widehat{CRCn} + \sum_i T^{-ni} \widehat{D}_i \oplus \sum_i T^{-ni} E_1 (D_i),$$

where T is the companion matrix used for computing the CRC check bytes, -n is any integer, i is the byte count in a sequence $D_i$ of all the data bytes and error correction check bytes of said record, except for a first preselected set of said error correction check bytes, and $E_1(D_i)$ is the sequence of error correction check bytes corresponding to the sequence, $D_i$,

second error syndrome computing means for computing the value of a second CRC error syndrome $S_{-(n+1)}(1)$ adjusted for error correction in accordance with the relation

$$S_{-(n+1)}(1) = \widehat{CRC(n+1)} \oplus \sum_i T^{-(n+1)i} \widehat{Z}_i \oplus \sum_i T^{-(n+1)i} E_1(Z_i),$$

where i is the byte count in a sequence $Z_i$ of all the data bytes and error correction check bytes in said record, except for a second preselected set of said error correction check bytes, and $E_1(Z_i)$ is the sequence of error correction check bytes corresponding to the sequence $Z_i$, and

means for utilising said two CRC error syndromes for performing said error correction operation.

8. Error correction apparatus as claimed in claim 7, for performing an error correction operation on a record having first and second level error correction check bytes, comprising second level processing means for processing second level error correction bytes,

characterised in that said second level processing means comprises

first partial processing means for computing a first partial value of the CRC error syndrome adjusted for second level error correction in accordance with the relation

$T^{-ni} E_2(D_i) = \log^{-1} \{[\log E_2(D_i) - ni] \text{ modulo } 255\}$

where i is the byte count in a sequence $D_i$ of all the data bytes in the record and all said first level error correction check bytes but excluding all said second level error correction check bytes, and $E_2$-$(D_i)$ is the sequence of second level error correction bytes corresponding to the sequence, $D_i$,

first combining means for combining the first partial value of the CRC error syndrome computed by the first partial processing means with the value of the CRC error syndrome computed by said first error syndrome computing means to produce a first total value of the CRC error syndrome,

second partial processing means for computing a second partial value of the CRC error syndrome adjusted for second error correction in accordance with the relation

$T^{-(n+1)i} E_2(Z_i) = \log^{-1} \{[\log E_2(Z_i) - (n+1)i] \text{ modulo } 255\}$,

where i is the byte count in a sequence $Z_i$ of all data bytes in the record and a predetermined number of said first level error correction check bytes but excluding all said second level error correction check bytes, and $E_2(Z_i)$ is the sequence of second-level error correction bytes corresponding

to the sequence, $Z_i$,

second combining means for combining the second partial value of the CRC error syndrome computed by said second partial processing means with the value of the CRC error syndrome computed by said second error syndrome computing means to produce a second total of the CRC error syndrome, and

means for utilising said first and second total values of said CRC error syndrome for performing said error correction operation.

9. A method of correcting errors in a record including a plurality of CRC check bytes generated by a method as claimed in claim 4, said method of correcting errors comprising performing a computing operation to compute the value of two CRC error syndromes for use in said error correction operation,

characterised in that said computing operation comprises

computing the value of a first CRC error syndrome $S_{-n}(1)$ adjusted for error correction in accordance with the relation

$$S_{-n}(1) = \hat{CRC}n \oplus \sum_i T^{-ni} \hat{D}_i \oplus \sum_i T^{-ni} E_1(D_i),$$

where T is the companion matrix used for computing the CRC check bytes, -n is any integer, i is the byte count in a sequence $D_i$ of all the data bytes and error correction check bytes of said record, except for a first preselected set of said error correction check bytes, and $E_1(D_i)$ is the sequence of error correction bytes corresponding to the sequence, $D_i$,

computing the value of a second CRC error syndrome $S_{-(n+1)}(1)$ adjusted for error correction in accordance with the relation

$$S_{-(n+1)}(1) = \hat{CRC}(n+1) \oplus \sum_i T^{-(n+1)i} \hat{Z}_i \oplus \sum_i T^{-(n+1)i} E_1(Z_i),$$

where i is the byte count in a sequence $Z_i$ of all the data bytes and error correction check bytes in said record, except for a second preselected set of error correction check bytes and $E_1(Z_i)$ is the sequence of error correction check bytes corresponding to the sequence, $Z_i$, and

utilising said two CRC error syndromes to correct said errors.

10. A method of correcting errors as claimed in claim 9, for correcting errors in a record having first and second level error correction check bytes, said method comprising processing second level error correction bytes,

characterised in that said second level processing operation comprises

computing a first partial value of the CRC error syndrome adjusted for second level error correction in accordance with the relation

$$T^{-ni} E_2(D_i) = \log^{-1}\{[\log E_2(D_i) - ni] \text{ modulo } 255\}$$

where i is the byte count in a sequence $D_i$ of all data bytes in the record and all said first level error correction check bytes but excluding all said second level error correction check bytes, and $E_2(D_i)$ is the sequence of second-level error correction bytes corresponding to the sequence, $D_i$,

combining the first partial value of the CRC error syndrome computed by the first partial processing means with the value of the CRC error syndrome computed by said first error syndrome computing means to produce a first total value of the CRC error syndrome,

computing a second partial value of the CRC error syndrome adjusted for second error correction in accordance with the relation

$$T^{-(n+1)i}E_2(Z_i) = \log^{-1}\{[\log E_2(Z_i) - (n+1)i] \text{ modulo } 255\},$$

where i is the byte count in a sequence $Z_i$ of all data bytes in the record and a predetermined number of said first level error correction check bytes but excluding all said second level error correction check bytes, and $E_2(Z_i)$ is the sequence of second-level error correction bytes corresponding to the sequence $Z_i$,

combining the second partial value of the CRC error syndrome computed by said second partial processing means with the value of the CRC error syndrome computed by said second error syndrome computing means to produce a second total of the CRC error syndrome, and

utilising said first and second total values of said CRC error syndrome to correct said errors.

## Patentansprüche

1. Eine Einrichtung zur Erzeugung einer Menge von CRC-Prüfungs-Bytes für einen Datensatz variabler Länge, der aus einer Folge von Daten-Bytes und Prüfungs-Bytes zur Fehlerkorrektur (ECC) besteht, die in die Daten-Bytefolge bei voreingestellten Intervallen eingefügt werden, wobei die berechneten ECC-Bytes Potenzen einer Begleitmatrix T verwenden, die von einem nicht reduzierbaren Polynom abgeleitet werden, und die Einrichtung darüber hinaus ein Rechensystem verwendet, das für die Bearbeitung der Folge von Daten-Bytes und ECC-Bytes angepaßt ist, um die Menge von CRC-Prüfungs-Bytes zu erzeugen;

   dadurch gekennzeichnet, daß das Rechensystem enthält:

   ein erstes Rechenmittel zur Erzeugung einer ersten Teilmenge von CRC-Prüfungs-Bytes, indem die Folge von Daten-Bytes und ECC-Bytes im Datensatz sequentiell empfangen wird, und für jedes CRC-Prüfungs-Byte $\Sigma T^{(-ni)}D_i$ berechnet wird, wobei $D_i$ der i-te Wert in der Folge von Daten-Bytes und ECC-Bytes ist, nachdem eine erste vorausgewählte Menge von ECC-Bytes ausgeschlossen wurde, T die Begleitmatrix ist, die für die Berechnung der ECC-Bytes verwendet wird, und n ein ganzzahliges Ungleiches von einer der Potenzen ist, die für die Berechnung der ECC-Bytes oder eines anderen CRC-Bytes verwendet werden;

   ein zweites Rechenmittel zur Erzeugung einer zweiten Teilmenge von CRC-Prüfungs-Bytes, die jeweils mit einem CRC-Prüfungs-Byte der ersten Teilmenge paarweise zusammengefaßt werden, wobei die Folge der Daten-Bytes und ECC-Bytes im Datensatz sequentiell empfangen und für jedes CRC-Prüfungs-Byte $\Sigma T^{(n+1)i}Z_i$ berechnet wird; $Z_i$ ist dabei der i-te Wert in der Folge von Daten-Bytes und ECC-Bytes, nachdem eine zweite vorausgewählte Menge von ECC-Bytes ausgeschlossen wurde, und n hat den gleichen Wert, der für die Erzeugung der paarweise zusammengefaßten CRC-Prüfungs-Bytes der ersten Teilmenge verwendet wird; und

   ein Mittel zum Zusammenfassen der ersten und zweiten Teilmenge der CRC-Prüfungs-Bytes, um die Menge der CRC-Prüfungs-Bytes zu erzeugen.

2. Eine Vorrichtung nach Anspruch 1, bei der ein Datensatz bearbeitet wird, der eine Folge von Daten-Bytes und eine Menge von Prüfungs-Bytes zur Fehlerkorrektur der ersten Stufe sowie eine Menge von Prüfungs-Bytes zur Fehlerkorrektur der zweiten Stufe darstellt,

   dadurch gekennzeichnet, daß

   die erste vorausgewählte Menge von Prüfungs-Bytes zur Fehlerkorrektur alle Prüfungs-Bytes zur Fehlerkorrektur der zweiten Stufe enthält, und

   die zweite vorausgewählte Menge von Prüfung-Bytes zur Fehlerkorrektur eine vorbestimmte Anzahl von Prüfungs-Bytes zur Fehlerkorrektur der ersten Stufe enthält.

3. Eine Einrichtung nach den Ansprüchen 1 oder 2, dadurch gekennzeichnet, daß die erste und zweite Teilmenge von CRC-Prüfungs-Bytes jeweils zwei Prüfungs-Bytes enthalten.

4. Ein Verfahren zur Erzeugung zahlreicher CRC-Prüfungs-Bytes für einen Datensatz variabler Länge, der aus einer Folge von Daten-Bytes und Prüfungs-Bytes zur Fehlerkorrektur (ECC) besteht, die in die Daten-Bytefolge bei voreingestellten Intervallen eingefügt werden, wobei zur Berechnung der ECC-Bytes Potenzen einer Begleitmatrix T verwendet werden, die von einem nicht reduzierbaren Polynom abgeleitet werden, und wobei eine Rechenoperation auf der Folge von Daten-Bytes und ECC-Bytes ausgeführt wird, um die Menge von CRC-Prüfungs-Bytes zu erzeugen;

   dadurch gekennzeichnet, daß die Rechenoperation umfaßt:

   die Erzeugung einer ersten Teilmenge von CRC-Prüfungs-Bytes, indem die Folge von Daten-Bytes und ECC-Bytes im Datensatz sequentiell empfangen wird, und für jedes CRC-Prüfungs-Byte $\Sigma T^{(-ni)}D_i$

berechnet wird, wobei $D_i$ der i-te Wert in der Folge von Daten-Bytes und ECC-Bytes ist, nachdem eine erste vorausgewählte Menge von ECC-Bytes ausgeschlossen wurde, T die Begleitmatrix ist, die für die Berechnung der ECC-Bytes verwendet wird, und n ein ganzzahliges Ungleiches von einer der Potenzen ist, die für die Berechnung der ECC-Bytes oder eines anderen CRC-Bytes verwendet werden;

die Erzeugung einer zweiten Teilmenge von CRC-Prüfungs-Bytes, die jeweils mit einem CRC-Prüfungs-Byte der ersten Teilmenge paarweise zusammengefaßt werden, wobei die Folge der Daten-Bytes und ECC-Bytes im Datensatz sequentiell empfangen und für jedes CRC-Prüfungs-Byte $\Sigma T^{(n+1)i} Z_i$ berechnet wird; $Z_i$ ist dabei der i-te Wert in der Folge von Daten-Bytes und ECC-Bytes, nachdem eine zweite vorausgewählte Menge von ECC-Bytes ausgeschlossen wurde, und n hat den gleichen Wert, der für die Erzeugung der paarweise zusammengefaßten CRC-Prüfungs-Bytes der ersten Teilmenge verwendet wird; und

die Zusammenfassung der ersten und zweiten Teilmenge der CRC-Prüfungs-Bytes, um die Menge der CRC-Prüfungs-Bytes zu erzeugen.

5.  Ein Verfahren nach Anspruch 4, bei dem ein Datensatz bearbeitet wird, der eine Folge von Daten-Bytes und eine Menge von Prüfungs-Bytes zur Fehlerkorrektur der ersten Stufe sowie eine Menge von Prüfungs-Bytes zur Fehlerkorrektur der zweiten Stufe darstellt,

dadurch gekennzeichnet, daß:

die erste vorausgewählte Menge von Prüfungs-Bytes zur Fehlerkorrektur alle Prüfungs-Bytes zur Fehlerkorrektur der zweiten Stufe enthält, und

die zweite vorausgewählte Menge von Prüfung-Bytes zur Fehlerkorrektur eine vorbestimmte Anzahl von Prüfungs-Bytes zur Fehlerkorrektur der ersten Stufe enthält.

6.  Ein Verfahren nach den Ansprüchen 4 oder 5, dadurch gekennzeichnet, daß die erste und zweite Teilmenge von CRC-Prüfungs-Bytes jeweils zwei Prüfungs-Bytes enthält.

7.  Eine Fehlerkorrektureinrichtung zur Durchführung einer Fehlerkorrektur in einem Datensatz, der über zahlreiche CRC-Prüfungs-Bytes (CRC) verfügt, die mittels des Verfahrens nach Anspruch 4 erzeugt wurden, wobei die Einrichtung ein Rechensystem zur Berechnung des Wertes von zwei CRC-Fehlersydromen umfaßt, die bei der Fehlerkorrektur verwendet werden,

dadurch gekennzeichnet, daß das Rechensystem enthält:

ein erstes Fehlersyndrom-Rechenmittel zur Berechnung des Wertes eines ersten CRC-Fehlersyndroms $S_{-n}(1)$, das für die Fehlerkorrektur entsprechend der nachfolgenden Gleichung angepaßt wurde:

$$S_{-n}(1) = \widehat{CRCn} + \sum_i T^{-ni}\hat{D_i} \oplus \sum_i T^{-ni}E_1(D_i)$$

wobei T die Begleitmatrix zur Berechnung der CRC-Prüfungs-Bytes ist, -n eine beliebige ganze Zahl, i die Byte-Zählung in einer Folge $D_i$ aller Daten-Bytes und Prüfungs-Bytes zur Fehlerkorrektur des Datensatzes ist, ausgenommen eine erste vorausgewählte Menge der Prüfungs-Bytes zur Fehlerkorrektur, und $E_1(D_i)$ die Folge der Prüfungs-Bytes zur Fehlerkorrektur ist, die der Folge $D_i$ entspricht,

ein zweites Fehlersyndrom-Rechenmittel zur Berechnung des Wertes eines zweiten CRC-Fehlersyndroms $S_{-(n+1)}(1)$, das für die Fehlerkorrektur entsprechend der nachfolgenden Gleichung angepaßt wurde:

$$S_{-(n+1)}(1) = \widehat{CRC}(n+1) \oplus \sum_i T^{-(n+1)i}\hat{Z_i} \oplus \sum_i T^{-(n+1)i}E_1(Z_i)$$

wobei i die Byte-Zählung in einer Folge $Z_i$ aller Daten-Bytes und Prüfungs-Bytes zur Fehlerkorrektur des Datensatzes ist, ausgenommen eine zweite vorausgewählte Menge der Prüfungs-Bytes zur Fehlerkorrektur, und $E_1(Z_i)$ die Folge der Prüfungs-Bytes zur Fehlerkorrektur ist, die der Folge $Z_i$ entspricht, und

13

ein Mittel zur Verwendung der beiden CRC-Fehlersyndrome, um die Fehlerkorrektur durchzuführen.

8. Eine Fehlerkorrektureinrichtung nach Anspruch 7 zur Durchführung einer Fehlerkorrektur in einem Datensatz mit Prüfungs-Bytes zur Fehlerkorrektur der ersten und zweiten Stufe, einschließlich Verarbeitungsmittel der zweiten Stufe zur Verarbeitung von Fehlerkorrektur-Bytes der zweiten Stufe, dadurch gekennzeichnet, daß das Verarbeitungsmittel der zweiten Stufe enthält:
ein erstes Teilverarbeitungsmittel zur Berechnung eines ersten Teilwertes des CRC-Fehlersyndroms, das für die Fehlerkorrektur der zweiten Stufe entsprechend der folgenden Gleichung angepaßt ist:

$$T^{-ni}E_2(D_i) = \log^{-1}\{[\log E_2(D_i) - ni]\ \text{Modulo}\ 255\}$$

wobei i die Byte-Zählung in einer Folge $D_i$ aller Daten-Bytes und aller Prüfungs-Bytes zur Fehlerkorrektur der ersten Stufe des Datensatzes ist, ausgenommen die Prüfungs-Bytes zur Fehlerkorrektur der zweiten Stufe, und $E_2(D_i)$ die Folge der Prüfungs-Bytes zur Fehlerkorrektur der zweiten Stufe ist, die der Folge $D_i$ entspricht,
ein erstes Mittel zum Zusammenfassen des ersten Teilwerts des CRC-Fehlersyndroms, der vom ersten Teilverarbeitungsmittel mit dem Wert des CRC-Fehlersyndroms errechnet wurde, der seinerseits vom ersten Fehlersyndrom-Rechenmittel errechnet wurde, um einen ersten Gesamtwert des CRC-Fehlersyndroms zu ermitteln,
ein zweites Teilverarbeitungsmittel zur Berechnung eines zweiten Teilwertes des CRC-Fehlersyndroms, das für die zweite Fehlerkorrektur entsprechend der folgenden Gleichung angepaßt ist:

$$T^{-(n+1)i}E_2(Z_i) = \log^{-1}\{[\log E_2(Z_i) - (n+1)i]\ \text{Modulo}\ 255\}$$

wobei i die Byte-Zählung in einer Folge $Z_i$ aller Daten-Bytes und einer vorbestimmten Anzahl von Prüfungs-Bytes zur Fehlerkorrektur der ersten Stufe des Datensatzes ist, ausgenommen die Prüfungs-Bytes zur Fehlerkorrektur der zweiten Stufe, und $E_2(Z_i)$ die Folge der Prüfungs-Bytes zur Fehlerkorrektur der zweiten Stufe ist, die der Folge $Z_i$ entspricht,
ein zweites Mittel zum Zusammenfassen des zweiten Teilwerts des CRC-Fehlersyndroms, der vom zweiten Teilverarbeitungsmittel mit dem Wert des CRC-Fehlersyndroms errechnet wurde, der seinerseits vom zweiten Fehlersyndrom-Rechenmittel errechnet wurde, um einen zweiten Gesamtwert des CRC-Fehlersyndroms zu ermitteln,
ein Mittel zur Verwendung des ersten und zweiten Gesamtwerts des CRC-Fehlersyndroms, um die Fehlerkorrektur durchzuführen.

9. Ein Verfahren zur Durchführung einer Fehlerkorrektur in einem Datensatz, der über zahlreiche CRC-Prüfungs-Bytes verfügt, die mittels des Verfahrens nach Anspruch 4 erzeugt wurden, wobei bei dem Verfahren zur Fehlerkorrektur eine Rechenoperation durchgeführt wird, bei der der Wert von zwei CRC-Fehlersydromen berechnet wird, die bei der Rechenoperation verwendet werden, dadurch gekennzeichnet, daß die Rechenoperation folgendes umfaßt:
die Berechnung des Wertes eines ersten CRC-Fehlersyndroms $S_{-n}(1)$, das für die Fehlerkorrektur entsprechend der nachfolgenden Gleichung angepaßt wurde:

$$S_{-n}(1) = \widehat{CRCn} \oplus \sum_i T^{-ni}\hat{D}_i \oplus \sum_i T^{-ni}E_1(D_i)$$

wobei T die Begleitmatrix zur Berechnung der CRC-Prüfungs-Bytes ist, -n eine beliebige ganze Zahl, i die Byte-Zählung in einer Folge $D_i$ aller Daten-Bytes und Prüfungs-Bytes zur Fehlerkorrektur des Datensatzes, ausgenommen eine erste vorausgewählte Menge der Prüfungs-Bytes zur Fehlerkorrektur, und $E_1(D_i)$ die Folge der Prüfungs-Bytes zur Fehlerkorrektur ist, die der Folge $D_i$ entspricht,
die Berechnung des Wertes eines zweiten CRC-Fehlersyndroms $S_{-(n+1)}(1)$, das für die Fehlerkorrektur entsprechend der nachfolgenden Gleichung angepaßt wurde:

$$S_{-(n+1)}(1) = \overset{\wedge}{CRC}(n+1) \oplus \sum_i T^{-(n+1)i}\overset{\wedge}{Z_i} \oplus \sum_i T^{-(n+1)i}E_1(Z_i)$$

wobei i die Byte-Zählung in einer Folge $Z_i$ aller Daten-Bytes und Prüfungs-Bytes zur Fehlerkorrektur des Datensatzes ist, ausgenommen eine zweite vorausgewählte Menge der Prüfungs-Bytes zur Fehlerkorrektur, und $E_1(Z_i)$ die Folge der Prüfungs-Bytes zur Fehlerkorrektur ist, die der Folge $Z_i$ entspricht, und

wobei die beiden CRC-Fehlersyndrome verwendet werden, um die Fehler zu korrigieren.

**10.** Ein Verfahren zur Fehlerkorrektur nach Anspruch 9 zur Durchführung einer Fehlerkorrektur in einem Datensatz mit Prüfungs-Bytes zur Fehlerkorrektur der ersten und zweiten Stufe, wobei das Verfahren die Verarbeitung der Fehlerkorrektur-Bytes der zweiten Stufe umfaßt,

dadurch gekennzeichnet, daß die Verarbeitung der zweiten Stufe beinhaltet:

die Berechnung eines ersten Teilwertes des CRC-Fehlersyndroms, das für die Fehlerkorrektur der zweiten Stufe entsprechend der folgenden Gleichung angepaßt ist:

$$T^{-ni}E_2(D_i) = \log^{-1}\{[\log E_2(D_i) - ni] \text{ Modulo } 255\}$$

wobei i die Byte-Zählung in einer Folge $D_i$ aller Daten-Bytes und aller Prüfungs-Bytes zur Fehlerkorrektur des Datensatzes ist, ausgenommen die Prüfungs-Bytes zur Fehlerkorrektur der zweiten Stufe, und $E_2(D_i)$ die Folge der Prüfungs-Bytes zur Fehlerkorrektur der zweiten Stufe ist, die der Folge $D_i$ entspricht,

das Zusammenfassen des ersten Teilwerts des CRC-Fehlersyndroms, der vom ersten Teilverarbeitungsmittel mit dem Wert des CRC-Fehlersyndroms errechnet wurde, der seinerseits vom ersten Fehlersyndrom-Rechenmittel errechnet wurde, um einen ersten Gesamtwert des CRC-Fehlersyndroms zu ermitteln,

die Berechnung eines zweiten Teilwertes des CRC-Fehlersyndroms, das für die zweite Fehlerkorrektur entsprechend der folgenden Gleichung angepaßt ist:

$$T^{-(n+1)i}E_2(Z_i) = \log^{-1}\{[\log E_2(Z_i) - (n+1)i] \text{ Modulo } 255\}$$

wobei i die Byte-Zählung in einer Folge $Z_i$ aller Daten-Bytes und einer vorbestimmten Anzahl von Prüfungs-Bytes zur Fehlerkorrektur der ersten Stufe des Datensatzes ist, ausgenommen die Prüfungs-Bytes zur Fehlerkorrektur der zweiten Stufe, und $E_2(Z_i)$ die Folge der Prüfungs-Bytes zur Fehlerkorrektur der zweiten Stufe ist, die der Folge $Z_i$ entspricht,

das Zusammenfassen des zweiten Teilwerts des CRC-Fehlersyndroms, der vom zweiten Teilverarbeitungsmittel mit dem Wert des CRC-Fehlersyndroms errechnet wurde, der seinerseits vom zweiten Fehlersyndrom-Rechenmittel errechnet wurde, um einen zweiten Gesamtwert des CRC-Fehlersyndroms zu ermitteln,

die Verwendung des ersten und zweiten Gesamtwerts des CRC-Fehlersyndroms, um die Fehlerkorrektur durchzuführen.

**Revendications**

**1.** Equipement destiné à générer un bloc d'octets de contrôle de redondance cyclique (CRC) pour un enregistrement de longueur variable constitué d'une suite d'octets de données et d'octets de contrôle de correction d'erreur (ECC), insérés dans la suite des octets de données à des intervalles prédéfinis, les octets de contrôle de correction d'erreur (ECC) étant calculés en utilisant les puissances d'une matrice associée T dérivée d'un polynôme irréductible, cet équipement comprenant un calculateur défini pour travailler sur ladite suite d'octets de données et d'octets de correction d'erreur, de façon à générer ledit bloc d'octets de contrôle CRC.

Caractérisé en ce que ledit calculateur comprend :

des premiers moyens de calcul pour générer un premier sous-ensemble d'octets de contrôle CRC, par lecture séquentielle des octets de données et des octets de correction d'erreur (ECC) dans ledit enregistrement et par calcul, pour chaque octet de contrôle CRC, de $\sum T^{(-ni)} D_i$, où $D_i$ est la ième

valeur de ladite suite des octets de données et de correction d'erreur ECC après avoir exclu un premier jeu présélectionné d'octets de correction d'erreur ECC, T est la matrice associée utilisée pour calculer lesdits octets de correction d'erreur ECC, et n est un entier différent de chacune des puissances utilisées pour calculer lesdits octets d'erreur ECC ou les autres octets de contrôle CRC ;

des seconds moyens de calcul pour générer un deuxième sous-ensemble d'octets de contrôle CRC, où chacun des octets est associé à un des octets de contrôle CRC du premier sous-ensemble, par lecture séquentielle de ladite suite d'octets de données et d'octets de correction d'erreur ECC dudit enregistrement et par calcul pour chaque octet de contrôle CRC, de $\Sigma\ T^{((n+1)i)}\ Z_i$, où $Z_i$ est la ième valeur dans ladite suite des octets de données et des octets de correction d'erreur ECC après avoir exclu un second jeu présélectionné d'octets de correction d'erreur ECC, et où n est la même valeur que celle utilisée pour calculer l'octet de contrôle CRC associé du premier sous-ensemble;

et des moyens pour combiner lesdits premier et second sous-ensembles d'octets de contrôle CRC, de façon à générer ledit bloc d'octets de contrôle CRC.

2. Equipement selon la revendication 1, pour travailler sur un enregistrement formé d'une suite d'octets de données, d'un bloc d'octets de contrôle d'erreur de premier niveau, et d'un bloc d'octets de contrôle d'erreur de second niveau,

caractérisé en ce que,

ledit premier jeu préselectionné d'octets de contrôle de correction d'erreur comprend tous lesdits octets de contrôle de correction d'erreur de deuxième niveau, et

ledit second jeu préselectionné d'octets de contrôle d'erreur comprend un nombre prédéterminé d'octets de contrôle de correction d'erreur de premier niveau.

3. Equipement selon les revendications 1 ou 2, caractérisé en ce que lesdits premier et second sous-ensembles d'octets de contrôle CRC contiennent chacun deux octets de contrôle.

4. Méthode pour générer une pluralité d'octets de contrôle de redondance cyclique (CRC) pour un enregistrement de longueur variable constitué d'une suite d'octets de données et d'octets de contrôle de correction d'erreur (ECC) insérés dans ladite séquence d'octets de données à des intervalles prédéfinis, les octets d'ECC étant calculés en utilisant les puissances d'une matrice associée T dérivée d'un polynôme irréductible, cette méthode comprenant l'exécution d'une opération de calcul sur ladite suite d'octets de données et d'octets d'ECC de façon à générer ladite suite d'octets de contrôle CRC,

caractérisée en ce que ladite opération de calcul comprend:

la génération d'un premier sous-ensemble d'octets de contrôle CRC, par lecture séquentielle de ladite suite d'octets de données et d'octets d'ECC dudit enregistrement et, pour chaque octet de contrôle d'erreur CRC, le calcul de $\Sigma\ T^{(-ni)}\ D_i$, où $D_i$ est la ième valeur dans ladite suite d'octets de données et d'octets d'ECC après avoir exclu un premier jeu prédéfini d'octets d'ECC, T est la matrice associée utilisée pour le calcul desdits octets d'ECC, et n est un entier différent de chacune des puissances utilisées pour calculer lesdits octets d'ECC ou tout autre octet de contrôle CRC ;

la génération d'un second sous-ensemble d'octets de contrôle CRC, où chacun des octets est associé à un des octets de contrôle CRC dudit premier sous-ensemble, par lecture séquentielle de ladite suite d'octets de données et d'octets d'ECC dans ledit enregistrement et, pour chaque octet de contrôle CRC, le calcul de $\Sigma\ T^{((n+1)i)}\ Z_i$, où $Z_i$ est la ième valeur de ladite suite d'octets de données et d'octets d'ECC après avoir exclu un second jeu prédéterminé d'octets d'ECC, et où n a la même valeur que celle utilisée pour générer l'octet de contrôle CRC associé du premier sous-ensemble ; et

la combinaison desdits premier et second sous-ensembles d'octets de contrôle CRC de façon à générer ledit ensemble d'octets de contrôle CRC.

5. Méthode, selon la revendication 4, pour travailler sur un enregistrement constitué d'une suite d'octets de données, d'un ensemble d'octets de correction d'erreur de premier niveau et d'un ensemble d'octets de correction d'erreur de second niveau,

caractérisée en ce que

ledit premier jeu prédéterminé d'octets de contrôle de correction d'erreur comprend tous les octets de contrôle de correction d'erreur de second niveau, et

ledit second jeu prédéterminé d'octets de contrôle de correction d'erreur comprend un nombre prédéterminé desdits octets de contrôle de correction d'erreur de premier niveau.

**6.** Méthode selon la revendication 4 ou la revendication 5, caractérisée en ce que lesdits premier et second sous-ensembles d'octets de contrôle CRC contiennent deux octets de contrôle.

**7.** Equipement de correction d'erreur, pour effectuer une opération de correction d'erreur sur un enregistrement comprenant une pluralité d'octets de contrôle CRC, générés par une méthode tel que défini dans la revendication 4, ledit équipement comprenant un calculateur pour calculer la valeur de deux syndromes d'erreur CRC afin de l'utiliser dans ladite opération de correction d'erreur,

caractérisé en ce que ledit calculateur comprend

des premiers moyens de calcul de syndrome d'erreur pour le calcul de la valeur d'un premier syndrome d'erreur CRC $S_{-n}(1)$ défini pour la correction d'erreur selon la formule

$$S_{-n}(1) = \widehat{CRCn} + \sum_i T^{-ni} \widehat{D_i} \oplus \sum_i T^{-ni} E_1(D_i)$$

où T est la matrice associée utilisée pour calculer les octets de contrôle CRC, -n est un entier quelconque, i est le numéro de l'octet dans la suite $D_i$ de tous les octets de données et octets de contrôle de correction d'erreur dans ledit enregistrement, et $E_1(D_i)$ est la suite des octets de contrôle de correction d'erreur correspondant à la séquence $D_i$,

des seconds moyens de calcul de syndrome d'erreur pour le calcul de la valeur d'un second syndrome d'erreur CRC $S_{-(n+1)}(1)$ défini pour la correction d'erreur selon la relation

$$S_{-(n+1)}(1) = \widehat{CRC}(n+1) \oplus \sum_i T^{-(n+1)i} \widehat{Z_i} \oplus \sum_i T^{-(n+1)i} E_1(Z_i)$$

où i est le rang de l'octet dans la suite $Z_i$ de tous les octets de données et octets de correction d'erreur dans ledit enregistrement, à l'exception d'un second jeu prédéfini d'octets de contrôle de correction d'erreur et $E_1(Z_i)$ est la suite des octets de contrôle de correction d'erreur correspondant à la suite $Z_i$, et

des moyens pour utiliser ces deux syndromes d'erreur CRC pour effectuer le calcul de ladite correction d'erreur.

**8.** Equipement de correction d'erreur selon la revendication 7, pour effectuer une opération de correction d'erreur sur un enregistrement ayant des octets de correction d'erreurs de premier et de second niveau, comprenant des moyens de calcul de second niveau pour calculer les octets de correction d'erreur de second niveau,

caractérisé en ce que lesdits moyens de calcul de second niveau comprennent

des premiers moyens de calcul partiel pour le calcul d'une première valeur partielle du syndrome d'erreur CRC défini pour une correction d'erreur de second niveau selon la relation

$T^{-ni} E_2(D_i) = \log^{-1} [ (\log E_2(D_1)-n_i) \text{ modulo } 255]$

où i est le rang de l'octet dans la suite $D_i$ de tous les octets de données dans l'enregistrement et de tous les octets de contrôle de correction d'erreur de premier niveau à l'exclusion des octets de contrôle de correction d'erreur de second niveau, et $E_2(D_i)$ est la suite des octets de correction d'erreur de second niveau correspondant à la suite $D_i$,

des premiers moyens de combinaison pour combiner la première valeur partielle du syndrome d'erreur CRC calculée par les premiers moyens de calcul partiel, avec la valeur du syndrome d'erreur CRC calculée par lesdits premiers moyens de calcul de syndrome d'erreur, pour calculer une première valeur totale du syndrome d'erreur CRC,

des seconds moyens de calcul partiel pour calculer une seconde valeur partielle du syndrome d'erreur CRC défini pour une correction d'erreur de second niveau selon la relation

$T^{-(n+1)i} E_2(Z_i) = \log^{-1} [(\log E_2(Z_i)-(n+1)i) \text{ modulo } 255]$

où i est le rang de l'octet dans la suite $Z_i$ formée par tous les octets de données dans l'enregistrement et par un nombre prédéterminé desdits octets de correction d'erreur de premier niveau à l'exclusion de tous les octets de correction d'erreur de second niveau, et $E_2(Z_i)$ est la suite des octets de correction d'erreur de second niveau correspondant à la suite $Z_i$,

des seconds moyens de combinaison pour combiner la seconde valeur partielle du syndrome d'erreur CRC calculée par lesdits seconds moyens de calcul partiel, avec la valeur du syndrome d'erreur CRC calculée par lesdits seconds moyens de calcul du syndrome d'erreur CRC, pour calculer une seconde valeur totale du syndrome d'erreur CRC, et

des moyens pour utiliser lesdites première et seconde valeurs totales dudit syndrome d'erreur CRC pour effectuer ladite correction d'erreur.

9. Méthode de correction d'erreur dans un enregistrement comprenant une pluralité d'octets de contrôle CRC générés par une méthode selon la revendication 4, ladite méthode de correction d'erreurs comprenant une opération de calcul pour calculer les valeurs de deux syndromes d'erreur CRC, destinées à être utilisées dans ladite opération de correction d'erreur,

caractérisée en ce que ladite opération comprend

le calcul de la valeur d'un premier syndrome d'erreur CRC $S_{-n}(1)$ défini pour la correction d'erreur selon la relation

$$S_{-n}(1) = \widehat{CRCn} \oplus \sum_i T^{-ni} \widehat{D_i} \oplus \sum_i T^{-ni} E_1(D_i)$$

où T est la matrice associée utilisée pour le calcul des octets de contrôle CRC, -n est un entier quelconque, i est le rang de l'octet dans la suite $D_i$ de tous les octets de données et des octets de contrôle de correction d'erreur dudit enregistrement, à l'exception d'un premier jeu prédéterminé d'octets de contrôle de correction d'erreur, et $E_1(D_i)$ est la suite des octets de correction d'erreur correspondant à la séquence $D_i$,

le calcul de la valeur d'un second syndrome d'erreur CRC $S_{-(n+1)}(1)$ défini pour la correction d'erreur selon la relation

$$S_{-(n+1)}(1) = \widehat{CRC(n+1)} \oplus \sum_i T^{-(n+1)i} \widehat{Z_i} \oplus \sum_i T^{-(n+1)i} E_1(Z_i)$$

où i est le rang de l'octet dans la suite $Z_i$ de tous les octets de données et octets de contrôle de correction d'erreur dudit enregistrement, à l'exception d'un second jeu prédéterminé d'octets de contrôle de correction d'erreur et $E_1(Z_i)$ est la suite des octets de contrôle de correction d'erreur correspondant à la suite $Z_i$, et

l'utilisation desdits deux syndromes d'erreur CRC pour corriger lesdites erreurs.

10. Méthode de correction d'erreur selon la revendication 9, pour corriger les erreurs dans un enregistrement comportant des octets de contrôle de correction d'erreur de premier et de second niveau, ladite méthode comprenant le traitement des octets de correction d'erreur de second niveau,

caractérisée en ce que ladite opération de traitement de second niveau comprend,

le calcul d'une première valeur partielle du syndrome d'erreur CRC défini pour une correction d'erreur de second niveau selon la relation

$$T^{-ni} E_2(D_i) = \log^{-1} [(\log E_2(D_i) - ni) \text{ modulo } 255]$$

où i est le rang de l'octet dans la suite Di pour tous les octets de données dans l'enregistrement et pour tous les octets de contrôle de correction d'erreur de premier niveau, à l'exclusion de tous les octets de contrôle de correction d'erreur de second niveau, et $E_2(D_i)$ est la suite d'octets de correction d'erreur de second niveau correspondant à la séquence $D_i$,

la combinaison de la première valeur partielle du syndrome d'erreur CRC calculée par les premiers moyens de calcul partiel, avec la valeur du syndrome d'erreur CRC calculée par lesdits premiers

18

moyens de calcul du syndrome d'erreur afin de générer une première valeur totale du syndrome d'erreur CRC,

le calcul d'une seconde valeur partielle du syndrome d'erreur CRC défini pour une correction d'erreur de second niveau selon la relation

$$T^{-(n+1)i} E_2(Z_i) = \log^{-1} [(\log E_2 (Z_i) - (n+1)i) \text{ modulo } 255]$$

où i est le rang de l'octet dans la suite $Z_i$ de tous les octets de données dans l'enregistrement et un nombre prédéterminé des octets de contrôle de correction d'erreur de premier niveau mais excluant tous les octets de contrôle de correction d'erreur de second niveau, et $E_2(Z_i)$ est la suite des octets de correction d'erreur de second niveau correspondant à la séquence $Z_i$,

la combinaison de la seconde valeur partielle du syndrome d'erreur CRC calculé par lesdits seconds moyens de calcul partiel avec la valeur du syndrome d'erreur CRC calculé par lesdits seconds moyens de calcul du syndrome d'erreur afin de générer une seconde valeur totale pour le syndrome d'erreur CRC, et

l'utilisation desdites première et seconde valeurs totales dudit syndrome d'erreur CRC pour corriger lesdites erreurs.

FIG. 1

$E_i(D_j)$

$\hat{D}_{j}-102$

MULTIPLICATION BY MATRIX T 3×102

20

21

MULTIPLICATION BY MATRIX T$^{-3}$

0

1

2

3

4

5

6

7

CLOCK SIGNAL

FIG. 2

| DATA BYTES | SUBBLOCK CK BYTES | BLOCK CK BYTES |

$D_7$ | $D_6$ $D_5$ $D_4$ $D_3$ $D_2$ $D_1$ | CRC1 CRC2 CRC3 CRC4 ECC ECC

$Z_7$ | $Z_6$ $Z_5$ $Z_4$ $Z_3$ $Z_2$ $Z_1$ | CRC1 CRC2 CRC3 CRC4 ECC ECC

**FIG. 3**